(19) Europäisches Patentamt / European Patent Office / Office européen des brevets

(11) **EP 2 650 471 B1**

(12) **FASCICULE DE BREVET EUROPEEN**

(45) Date de publication et mention de la délivrance du brevet:
**05.08.2020   Bulletin 2020/32**

(51) Int Cl.:
*E21B 43/30* *(2006.01)*          *G06Q 10/04* *(2012.01)*

(21) Numéro de dépôt: **13305330.6**

(22) Date de dépôt: **19.03.2013**

(54) **Procédé de sélection des positions de puits a forer pour l'exploitation d'un gisement pétrolier**

Verfahren zur Auswahl der Position von Bohrbrunnen zur Förderung eines Erdöllagers

Method for selecting positions of wells to be drilled for exploiting an oil field

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **10.04.2012  FR 1201057**

(43) Date de publication de la demande:
**16.10.2013   Bulletin 2013/42**

(73) Titulaire: **IFP Energies nouvelles**
**92500 Rueil-Malmaison (FR)**

(72) Inventeurs:
• **Bouzarkouna, Zyed**
**75013 Paris (FR)**
• **Ding, Didier Yu**
**78230 Le Pecq (FR)**
• **Auger, Anne**
**92160 Antony (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**EP-A1- 2 253 797**

• **HONGGANG WANG ET AL: "Use of retrospective optimization for placement of oil wells under uncertainty", WINTER SIMULATION CONFERENCE (WSC), PROCEEDINGS OF THE 2010, IEEE, PISCATAWAY, NJ, USA, 5 décembre 2010 (2010-12-05), pages 1750-1757, XP031842679, ISBN: 978-1-4244-9866-6**

## Description

La présente invention concerne le domaine technique de l'industrie pétrolière, et plus particulièrement l'optimisation de placement des puits, ou zones de drainage, dans un réservoir pétrolier pour produire des hydrocarbures.

Pour produire un gisement pétrolier, les ingénieurs réservoirs cherchent à définir les meilleurs positions et trajectoires des puits à forer correspondant aux meilleures zones de drainages. Ces puits sont généralement des puits producteurs qui permettent de faire remonter les hydrocarbures depuis le réservoir jusqu'à la surface, ou parfois des puits injecteurs, par exemple d'eau ou de gaz, pour améliorer la récupération des hydrocarbures contenus dans le réservoir.

Le forage des puits est une décision importante dans la vie d'un gisement pétrolier, vu que forer un puits est une action couteuse à la fois en argent et en temps. Pour cette raison, les ingénieurs réservoir utilisent généralement deux outils.

- un premier outil appelé "modèle de réservoir" qui constitue une image représentative de la structure du réservoir ainsi que de son comportement. Cette image ou représentation est construite à partir des données collectés sur le champ pétrolier considéré (carottes, diagraphies, sismiques,...) réalisées par des géologues, des géophysiciens, des pétrophysiciens et un ordinateur. Cependant, en pratique, les géologues, les géophysiciens et les pétrophysiciens ne possèdent pas suffisamment des données pour construire un modèle qui correspond parfaitement au sous-sol. Donc, l'approche usuelle bien connue par les spécialistes est de construire plusieurs modèles de réservoir représentant des propriétés, par exemple pétrophysiques, différentes. Chaque modèle de réservoir est considéré comme une image possible de la structure du réservoir et de son comportement. L'incertitude sur la connaissance précise du réservoir est donc prise en compte en produisant plusieurs images possibles du réservoir.

- un deuxième outil appelé "simulateur d'écoulement". Un simulateur d'écoulement est un logiciel qui a pour objectif de modéliser les écoulements des fluides au sein du réservoir pétrolier représenté par un modèle de réservoir. Par exemple, ce logiciel permet d'estimer pour une configuration de puits donnée et pour un intervalle de temps donné, les quantités produites d'eau, d'huile et de gaz. PumaFlow® (IFP Energies nouvelles, France) est un exemple de simulateur d'écoulement.

On connait des techniques permettant d'optimiser l'emplacement des zones de drainage en utilisant plusieurs modèles de réservoir possibles et un simulateur d'écoulement.

On connait par exemple les méthodes suivantes:

- Guyaguler, B. and Horne, R.N. 2001. Uncertainty assessment of well placement optimization. In: SPE annual technical conférence and exhibition. SPE 71625

- Ozdogan, U. and Horne, R.N. 2006. Optimization of Well Placement Under Time-Dependent Uncertainty. SPE Res Eval & Eng 9 (2): 135-145. SPE-90091-PA

- Alhuthali, A.H., Datta-Gupta, A., Yuen, B. and Fontanilla, J.P. 2010. Optimizing smart well controls under geologic uncertainty. Journal of Petroleum Science and Engineering 73 (1-2): 107-121.

- Schulze-Riegert, R., Bagheri, M., Krosche, M., Kuck, N. and Ma, D. 2011. Multiple-objective optimization applied to well path design under geological uncertainty. In SPE reservoir simulation symposium. SPE 141712

Cependant, ces approches représentent un processus long et fastidieux nécessitant un nombre très élevé de simulations d'écoulement au moyen du simulateur d'écoulement. En effet, pour chaque configuration des zones de drainage considérée, ces méthodes effectuent une simulation d'écoulement pour chaque modèle de réservoir possible, pour les combiner après en utilisant un critère de qualité, classiquement, défini comme étant un paramètre appelé « Net Present Value », ou NPV. Le NPV est la différence des flux de trésorerie généré par l'investissement correspondant au placement des zones de drainage.

Pour répondre aux besoins des ingénieurs et des spécialistes en charge de l'exploitation du réservoir pétrolier, il est essentiel de réduire le nombre de simulations d'écoulements pour optimiser le placement des zones de drainage sur plusieurs modèles de réservoir possibles.

Pour réduire le nombre de simulations d'écoulement, on connaît la méthode décrite dans le document suivant :

- Wang, H., Echeverria Ciaurri, D., Durlofsky, L.J. and Cominelli, A. 2011. Optimal well placement under uncertainty using a Retrospective Optimization framework. In: SPE Reservoir Simulation Symposium. SPE 141950-MS

Cette méthode propose d'utiliser un nombre limité (choisi par l'ingénieur ou l'utilisateur de la méthode) de modèles de réservoir au début de l'optimisation, puis d'utiliser de plus en plus (d'une façon choisi par l'ingénieur ou l'utilisateur de l'approche) de modèles en fonction de l'évolution de l'optimisation. En pratique, il est difficile pour l'ingénieur de choisir ce nombre de modèles à utiliser à chaque étape ou itération de la méthode. De plus, au cours des dernières générations, on considère pour chaque configuration de zones de drainage, un nombre élevé (21 ou 104 dans l'exemple proposé) de modèles de réservoir possibles, et donc de faire un nombre élevé de simulations de réservoir pour chaque configuration des zones de drainage. En pratique, il est très difficile aussi d'effectuer ce nombre élevé de simulations d'écoulement.

Ainsi, l'objectif de l'invention concerne un procédé pour optimiser le placement des puits à partir de plusieurs modèles de réservoir possibles, dans laquelle le nombre de simulations d'écoulement est réduit. Le procédé se base sur l'utilisation des résultats de simulations d'écoulement effectués tout au long de la procédure d'optimisation, et ainsi défini un nouveau critère de qualité qui approche le NPV mais nécessitant un nombre réduit (voir une seule) de simulations d'écoulement.

L'invention se rapporte à un procédé d'exploitation d'un réservoir souterrain tel que défini par la revendication 1. des modes préférentiels de réalisation sont définis par les revendications dépendantes 2 à 7.

D'autres caractéristiques et avantages du procédé selon l'invention, apparaîtront à la lecture de la description ci-après d'exemples non limitatifs de réalisations, en se référant aux figures annexées et décrites ci-après.

## Présentation sommaire des figures

- La figure 1 montre le maillage du réservoir utilisé. Elle comporte une vue en perspective du réservoir et une vue de dessus, et présente l'élévation verticale du réservoir.
- La figure 2 montre l'évolution de la meilleure valeur de critère de qualité approché trouvé en utilisant la méthode selon l'invention. L'axe des abscisses présente le nombre de simulations de réservoir utilisées. L'axe des ordonnées présente la valeur du critère de qualité approché.
- La figure 3 montre l'évolution de la meilleure valeur de vrai critère de qualité trouvé en utilisant la méthode selon l'invention. L'axe des abscisses présente le nombre de simulations de réservoir utilisées. L'axe des ordonnées présente la valeur du vrai critère de qualité.
- La figure 4 montre l'évolution de la meilleure valeur du critère de qualité approché trouvé en utilisant la méthode selon l'invention. Les points correspondent à chaque évaluation du vrai critère de qualité. L'axe des abscisses présente le nombre de simulations de réservoir utilisées. L'axe des ordonnées présente la valeur du critère de qualité (approché ou vrai).
- La figure 5 montre l'évolution de la meilleure valeur de NPV trouvé en utilisant la méthode selon l'invention et la compare avec celle trouvée en utilisant l'approche conventionnelle. L'axe des abscisses présente le nombre de simulations de réservoir utilisées. L'axe des ordonnées présente la valeur du NPV.
- La figure 6 montre une vue de dessus du maillage du réservoir. Elle montre aussi les emplacements des puits à forer obtenus en utilisant la méthode selon l'approche conventionnelle: le producteur, noté P1, et l'injecteur, noté I1.
- La figure 7 montre une vue de dessus du maillage du réservoir. Elle montre aussi les emplacements des puits à forer obtenus en utilisant la méthode selon l'invention: le producteur, noté P1, et l'injecteur, noté I1.

## Description du procédé

L'objet de l'invention concerne une technique de décision de placement des puits dans un réservoir, en prenant en compte l'incertitude sur la connaissance du réservoir avec un nombre réduit de simulations de réservoir. On appelle « puits » toute zone de drainage. La méthode utilise une optimisation d'un critère de qualité approché permettant d'obtenir un résultat satisfaisant du vrai critère de qualité (moyenne des NPV ou des productions des zones de drainage sur tous les modèles de réservoir). La réduction du nombre de simulations de réservoir permet l'application industrielle par l'ingénieur réservoir.

A partir d'un ensemble d'images du réservoir (modèles de réservoir), le procédé d'exploitation d'un réservoir souterrain selon l'invention comporte les étapes principales suivantes :

1. on définit un nombre de puits à forer au sein du réservoir

2. on génère aléatoirement des configurations de puits

3. on optimise lesdites configurations en calculant un premier critère de qualité (critère approché)

4. on calcule pour les configurations optimisées, un second critère de qualité (vrai critère)

5. on fore les puits aux emplacements choisis.

On commence par définir un ensemble de modèles de réservoir (d'images du réservoir) qui correspondent chacun à une grille définie par les propriétés du réservoir comme la porosité, la perméabilité... Ces modèles sont construits à partir de mesures collectées du réservoir à l'aide d'une méthode géostatistique.

On choisit également un simulateur d'écoulement. On peut utiliser par exemple le logiciel PumaFlow™ (IFP Energies nouvelles, France).

### 1. Définition du nombre de puits à forer au sein du réservoir

On définit dans cette étape le nombre de puits à forer au sein du réservoir. Ces puits définissent des zones de drainage. On définit dans cette étape le type de chaque puits : producteur ou injecteur. Pour les puits injecteurs, on définit aussi le type du fluide à injecter (eau, gaz,...).

### 2. Génération aléatoire des configurations de puits

Une configuration de puits correspond à l'emplacement, au sein du réservoir, de l'ensemble des puits à forer dans le réservoir.

On définit un paramètre À, dit taille de population, caractérisant le nombre de configurations de puits utilisées à chaque génération. La population initiale (première itération) est générée aléatoirement.

La configuration de puits est représentée par la localisation de chaque puits au sein du réservoir. Il peut s'agir des coordonnées des points définissants les extrémités, au sein du réservoir, des puits et de ses drains latéraux. La dimension du problème est ainsi égale au nombre de variables utilisées pour représenter la configuration de puits.

### 3. Optimisation des configurations en calculant un critère de qualité approché

#### 3.1 Choix d'un critère de qualité approché de l'exploitation du réservoir

La qualité de l'exploitation de réservoir est classiquement, défini comme étant un paramètre appelé "Net Present Value", ou NPV. Le NPV est la différence des flux de trésorerie généré par l'investissement correspondant au placement des zones de drainage.

Dans cette étape, on définit un critère de qualité de l'exploitation du réservoir remplaçant le critère de qualité vrai de l'étape 4.1.

La qualité approchée de l'exploitation du réservoir est calculée en utilisant un nombre réduit de nouvelles simulations d'écoulement et un nombre de résultats de simulations déjà existantes avec d'autres configurations de zones de drainages qui sont proches de la configuration considérée. Ainsi, on calcule un premier critère de qualité de l'exploitation du réservoir au moyen d'un simulateur d'écoulement appliqué à un nombre restreint d'image du réservoir et au moyen de résultats de simulations de configuration obtenus préalablement pour des configurations proches, par rapport à une distance, de la configuration à évaluer, ladite distance étant fonction des coordonnées des puits.

Les résultats de simulations de configuration obtenus préalablement sont obtenus au cours de l'optimisation ou obtenus en calculant un second critère de qualité (voir étape 4.1).

En effet, pour une configuration de zones de drainage donnée, on effectue les étapes suivantes :

**3.1.1** on sélectionne un nombre $N_N$ ("Number of neighbor points") de configurations de zone de drainage les plus proches, au sens d'une distance, de la configuration de zones de drainage considéré. Ces $N_N$ configurations sont sélectionnées parmi les configurations de zones de drainage déjà simulées avec un simulateur d'écoulement. On note par $N_S$ le nombre de configurations de zones de drainage déjà simulé pour lesquelles on dispose les résultats de simulation d'écoulement. $N_N$ doit être inférieur ou égal à $N_S$. On note par $\tilde{C}_i$ les résultats de simulation correspondants, à chaque configuration de zones de drainage sélectionnée. Typiquement $N_N$ est égale à min($2*N_R$, $N_S$);

**3.1.2** on sélectionne aléatoirement un nombre $N_M$ de modèles de réservoir, sur chacune on effectue une simulation d'écoulement de la configuration de zone de drainage considéré. On note par $C_j$ les résultats de simulation correspondants, à la configuration de zone de drainage considérée, à chaque modèle de réservoir sélectionné. Typiquement, $N_M$ est égale à 1. Ceci signifie qu'on effectue une seule simulation d'écoulement;

**3.1.3** on choisit une fonction d'attribution de poids aux différents critères de qualités, i.e., on associe une valeur de poids à chaque résultat de simulation $\tilde{C}_i$ ou $C_j$. Les valeurs de poids sont normalisées entre 0 et 1. Typiquement, les valeurs des poids correspondants aux $C_j$ sont plus importantes que celles des poids correspondants aux $\tilde{C}_i$. Typiquement aussi, les valeurs des poids correspondants aux $C_j$ sont égales. Typiquement enfin, les valeurs des poids correspondants aux $\tilde{C}_i$, doivent être décroissante en fonction de la distance de la configuration sélectionnée de la configuration considérée. On note dans ce qui suit par $p_j$ les $N_M$ valeurs de poids correspondant à chaque $C_j$ et par $\tilde{p}_i$ les $N_S$ valeurs de poids correspondants à chaque $\tilde{C}_i$.

En particulier, un moyen de définir les $N_M$ valeurs de poids $p_j$ et les $N_S$ valeurs de $\tilde{p}_i$ est de définir une distance maximale dite de sélection égal à $h$ (par exemple égale à 4000). Ensuite, pour chaque $\tilde{p}_i$, on note par $d_i$ la distance entre la configuration sélectionnée et la configuration considérée. On peut définir donc $p_j$ et $\tilde{p}_i$ de la façon suivante:

$$p_j \leftarrow 1, \text{ pour } j = 1,...,N_M$$

$$\tilde{p}_i \leftarrow \left(1-(\frac{d_i}{h})^2\right)^2, \text{ pour } i = 1,...,N_S$$

$$S = \sum_{j=1}^{N_M} p_j + \sum_{i=1}^{N_S} \tilde{p}_i$$

$$p_j \leftarrow \frac{p_j}{S}$$

$$\tilde{p}_i \leftarrow \frac{\tilde{p}_i}{S}$$

**3.1.4** On définit le critère de qualité approchée de l'exploitation du réservoir, noté Q, comme suit:

$$Q = \sum_{j=1}^{N_M} p_j C_j + \sum_{i=1}^{N_S} \tilde{p}_i \tilde{C}_i$$

La définition du critère de qualité utilise, pour une configuration de zones de drainage donnée, seulement $N_M$ simulation d'écoulement. Typiquement, comme indiqué ci-dessus, $N_M$ est égale à 1.

*3.2 Optimisation*

Dans cette étape, on optimise le critère de qualité approché de l'exploitation du réservoir comme défini à l'étape 3.1, moyennant un algorithme d'optimisation stochastique. Cet algorithme peut être par exemple un algorithme du type CMA-ES ("Covariance Matrix Adaptation - Evolution Strategy"), décrit dans:

N. Hansen and A. Ostermeier. 2001. Completely derandomized self-adaptation in évolution strategies. Evolutionary Computation, 9(2): 159-195.

Selon un mode de réalisation, l'algorithme est initialisé à partir des configurations de puits obtenues à l'étape 2, et les paramètres de l'optimisation, qui sont définis par les paramètres de configurations de puits, sont modifiés moyennant l'algorithme d'optimisation de façon à maximiser le critère de qualité approché de l'exploitation du réservoir comme défini à l'étape 3.1. Cette étape continue jusqu'à atteindre un critère de d'arrêt fixé, qui peut porter en pratique sur un nombre maximal de simulations de réservoir à effectuer.

4. Choix des meilleurs emplacements de chaque puits

On calcule pour les configurations optimisées à l'étape précédente, un second critère de qualité de l'exploitation du réservoir au moyen d'un simulateur d'écoulement appliqué à chaque image du réservoir, et l'on choisit l'emplacement des puits correspondant à la configuration optimisée ayant le meilleur second critère de qualité.

*4.1 Calcul d'un second critère de qualité (vrai critère)*

Pour un nombre $N_R$ de modèles de réservoir, le NPV peut être défini pour une configuration des zones de drainage donnée comme étant une moyenne des NPV sur tous les modèles réservoir défini dans l'étape 1.

On peut également utiliser une autre forme de qualité comme par exemple utiliser la différence entre la moyenne des NPV sur tous les modèles de réservoir et l'écart type des NPV sur tous les modèles réservoir.

D'une façon générale, le critère de qualité de l'exploitation de réservoir, noté *C*, est évalué comme suit:

$$C = \frac{1}{N_R} \sum_{1}^{N_R} C_i \,,$$

avec $C_i$ le résultat de simulation associé au modèle de réservoir *i*. Typiquement, C correspond au NPV, et chaque $C_i$ correspond à un NPV évalué avec un modèle de réservoir donné. Le calcul d'une valeur de $C_i$ nécessite une simulation d'écoulement.

D'une façon générale, le calcul du critère de qualité de l'exploitation du réservoir, permettant de mesurer la qualité d'une configuration de zones de drainages donnée, nécessite donc un nombre de simulations d'écoulements égal au nombre de modèles de réservoir considéré qui est égal à $N_R$.

*4.2 Choix des meilleurs emplacements de chaque puits*

Dans cette étape on commence par choisir un nombre d'emplacements de chaque zone de drainage candidats à être parmi les meilleurs emplacements parcourus pendant l'étape précédente. Un moyen est de choisir le meilleur emplacement obtenu à chaque itération. Un autre moyen peut être par exemple de choisir seulement le meilleur emplacement obtenu à chaque génération s'il représente le meilleur par rapport à tous les points parcourus (avant cette génération) durant toute l'étape précédente.

Une fois que l'on a choisi des emplacements candidats à être les meilleurs emplacements, on effectue pour chaque emplacement choisi des simulations d'écoulements avec tous les modèles de réservoir, et on calcule le critère de qualité comme défini à l'étape 4.1.

Puis, on choisit un des emplacements défini à l'étape précédente. Généralement, il s'agit de prendre la configuration des zones de drainage qui offre le meilleur critère de qualité et qu'il est techniquement possible de forer.

5. Forage des puits aux emplacements choisis.

Dans cette étape, on fore les puits définis dans l'étape précédente.

**Exemple d'application**

La méthode de placement des puits dans un réservoir incertain selon l'invention peut être utilisée pour placer de nouveaux puits ou ajouter des nouveaux latéraux à des puits déjà existants. Elle peut être appliquée sur des nouveaux champs ou des champs matures (contenant des puits déjà forés). L'incertitude du réservoir est définie moyennant un nombre de modèles de réservoir équiprobables. Ici, nous présentons en particulier un exemple d'application pour le placement d'un puits producteur et un puits injecteur dans un nouveau champ avec 20 modèles de réservoir possibles.

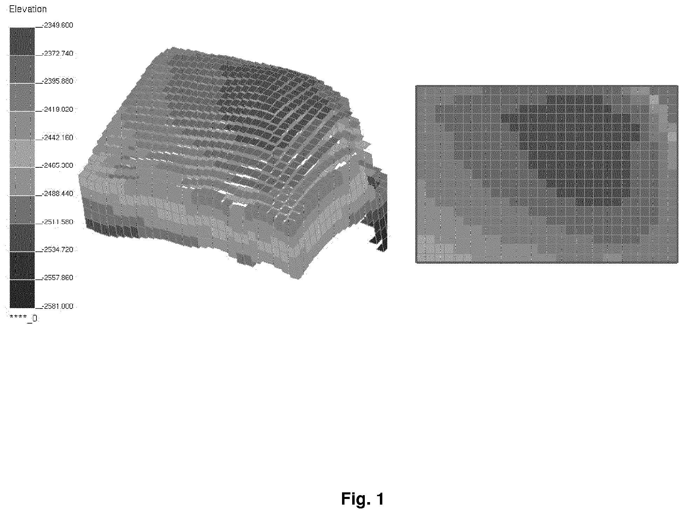

Cette méthode est appliquée sur un réservoir synthétique. Le réservoir est de taille 3420m x 5040m x 90m. Le maillage est cartésien avec 19 mailles dans la direction **x.** 28 mailles dans la direction **y** et 5 mailles dans la direction **z.** La taille des mailles est de 180m x 180m x 18m. La figure 1 montre le maillage du réservoir utilisé. Elle comporte une vue en perspective du réservoir et une vue de dessus, et présente l'élévation verticale du réservoir.

Le champ considéré ne contient aucun puits déjà foré. On propose de trouver le meilleur placement pour chacun des deux puits avec uniquement un tronc principal (sans latéraux), avec la méthode selon l'invention. Le vrai critère de qualité C est choisi comme étant la valeur moyenne de NPV sur les 20 modèles de réservoir:

$$C = \frac{1}{20} \sum_{m=1}^{20} \left( \sum_{n=1}^{Y} \left( \frac{1}{(1+APR)^n} \left[ Q_{n,o} \times C_{n,o} + Q_{n,g} \times C_{n,g} + Q_{n,wa} \times C_{n,wa} \right] \right) - C_d \right)_m$$

où $Q_{n,p}$ est la production du champ considéré en phase *p* dans la période *n* sur le modèle de réservoir *m, $C_{n,p}$* est le gain ou la perte associé à la production de la phase *p* pendant la période *n,* la phase *p* peut représenter l'huile, le gaz ou l'eau qui sont notés respectivement par *o, g, wa.* APR est le taux d'intérêt annuel. Y est le nombre de périodes considérées, $C_d$ est le cout nécessaire pour le forage et la complétion pour les puits considérés, $C_d$ est approximé comme suit :

$$C_d = \sum_{k=0}^{N} [A.d_w . \ln(l_w).l_w]_k$$

avec $l_w$ la longueur du puits, $d_w$ le diamètre du puits, A une constante, $N$ le nombre total de puits.

Les productions $Q_{n,p}$ de la phase $p$ pour la période $n$ sur le modèle de réservoir $m$ sont obtenus moyennant le simulateur de réservoir. Dans cet exemple on utilise le simulateur de réservoir PumaFlow™ (IFP, France).

Dans cet exemple, $N$ = 2. Les constantes utilisées pour définir la fonction objectif sont représentées dans le tableau suivant :

| Constante | Valeur |
|---|---|
| $C_{n,o}$ | 60 \$ / baril |
| $C_{n,g}$ | -4 \$ /baril |
| $C_{n,w}$ | 0 |
| APR | 0.2 |
| A | 1000 |
| $d_w$ | 0.1 m |

Les pressions limites sont imposées au fond de ces deux puits.

On utilise l'algorithme d'optimisation CMA-ES pour optimiser les 12 paramètres représentant les 2 puits (6 paramètres par puits correspondant aux coordonnées des extrémités de chaque puits). On choisit une taille de population égale à 40 individus.

On définit un critère de qualité approché $\tilde{C}$. Pour calculer $\tilde{C}$ pour une configuration de zone de drainage donnée, on commence par sélectionner un nombre $N_S$ de configurations de zone de drainage déjà simulées. Ce nombre est égal au maximum 40, et correspond au nombre de configurations de zone de drainage avec une distance au maximum égale à 4000. La distance entre deux configurations de puits $q_1$ et $q_2$ est calculée comme suit:

$$d(q_1, q_2) = \sqrt{(q_1 - q_2)^T C^{-1} (q_1 - q_2)} \quad \forall q_1, q_2 \in \Re^n .$$

On note par $\tilde{C}_i$, $i$ = 1,...,$N_s$ les valeurs de NPV des $N_S$ configurations de zones de drainage sélectionnées et par $d_i$ les distance entre chacun des $N_S$ configurations de zones de drainage sélectionnées et la configuration de zone de drainage à évaluer.

On effectue après une seule simulation de réservoir pour la configuration de zone de drainage à évaluer en utilisant un modèle de réservoir sélectionné aléatoirement, et on note $C_1$ la valeur de NPV qui correspond à cette simulation.

Le critère de qualité approché est ainsi calculé comme étant:

$$Q = p_1 C_1 + \sum_{i=1}^{N_S} \tilde{p}_i \tilde{C}_i$$

avec : $p_1$ et $\tilde{p}_i$ calculé et normalisé comme suit:

$$p_1 \leftarrow 1,$$

$$\tilde{p}_i \leftarrow \left(1 - (\frac{d_i}{h})^2\right)^2 , \text{ pour } i = 1,...,N_S$$

$$S = p_1 + \sum_{i=1}^{N_S} \tilde{p}_i$$

$$p_1 \leftarrow \frac{p_1}{S}$$

$$\tilde{p}_i \leftarrow \frac{\tilde{p}_i}{S}$$

Si aucune configuration de zones de drainage n'a été sélectionnée (dans le cas ou on n'a pas encore simulé aucune configuration de zone de drainage ou si toutes les zones de drainage déjà simulées sont à une distance supérieur à 4000 par rapport à la configuration de zone de drainage à évaluer), le critère de qualité approché sera simplement égal à $C_1$.

La population initiale (de taille 40) est échantillonnée aléatoirement dans le réservoir. La meilleure valeur de critère de qualité approché obtenu initialement est égale à 7.84E9. L'optimisation du critère de qualité approché utilise 7000 simulations de réservoir pour atteindre une valeur de critère de qualité approché égale à 1.16E10.

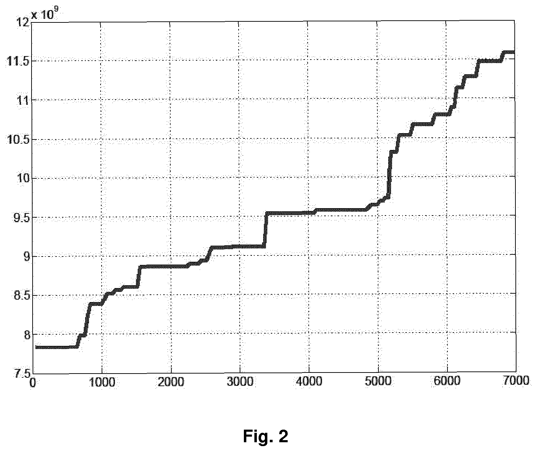

Au cours du processus d'optimisation, la méthode selon l'invention réussit à trouver une série de configurations de zone de drainage, i.e., avec un meilleur critère de qualité approché. La figure 2 montre l'évolution de la meilleure valeur de critère de qualité approché trouvé en utilisant la méthode selon l'invention. L'axe des abscisses présente le nombre de simulations de réservoir utilisées. L'axe des ordonnées présente la valeur du critère de qualité approché. On sélectionne finalement 30 configurations de zone de drainage de l'optimisation effectué. Une configuration de zone de drainage est sélectionnée si sa valeur de critère de qualité approchée représente la meilleure valeur trouvée au cours de l'optimisation.

On effectue 20 simulations de réservoir pour chaque configuration de zone de drainage sélectionnée, i.e., pour chaque modèle de réservoir. Ainsi, on effectue 600 (= 20 x 30) simulations de réservoir.

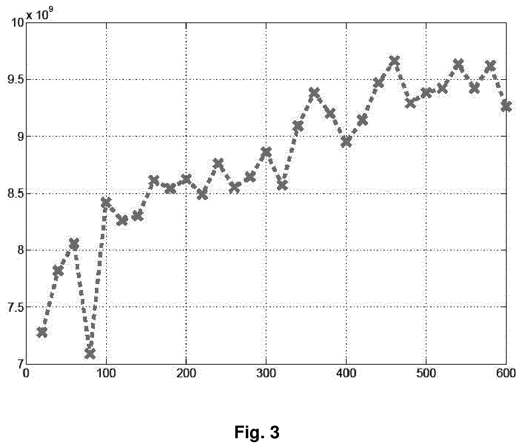

Les résultats des 30 évaluations de vrai critère de qualité pour les configurations de zones de drainage sélectionnées sont reportés à la figure 3. Cette figure montre l'évolution de la meilleure valeur de vrai critère de qualité trouvé en utilisant la méthode selon l'invention. L'axe des abscisses présente le nombre de simulations de réservoir utilisées. L'axe des ordonnées présente la valeur du vrai critère de qualité. Chaque point de la courbe correspond à 20 simulations de réservoir effectuées.

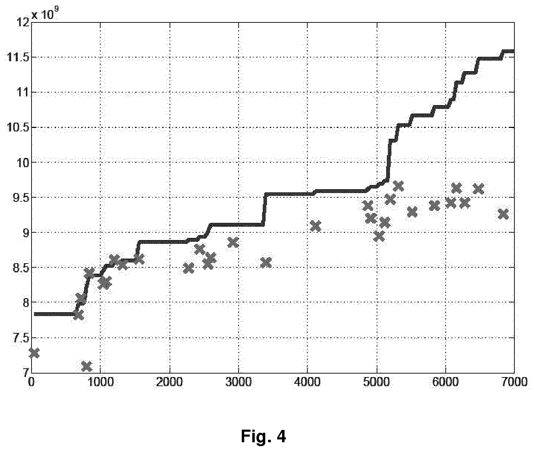

Les résultats des 30 évaluations de vrai critère de qualité sont montrées dans la figure 4, ensemble avec les résultats des évaluations du critère approché. Cette figure montre l'évolution de la meilleure valeur du critère de qualité approché trouvé en utilisant la méthode selon l'invention. Les points correspondent à chaque évaluation du vrai critère de qualité. L'axe des abscisses présente le nombre de simulations de réservoir utilisées. L'axe des ordonnées présente la valeur du critère de qualité (approché ou vrai).

La méthode selon l'invention permet donc d'avoir une meilleure valeur du vrai critère de qualité (moyenne de NPV sur tous les modèles de réservoir) égaie à 9.66E9.

Avec cette méthode, nous pouvons obtenir une meilleure configuration de zone drainage avec un nombre techniquement abordable de simulations de réservoir.

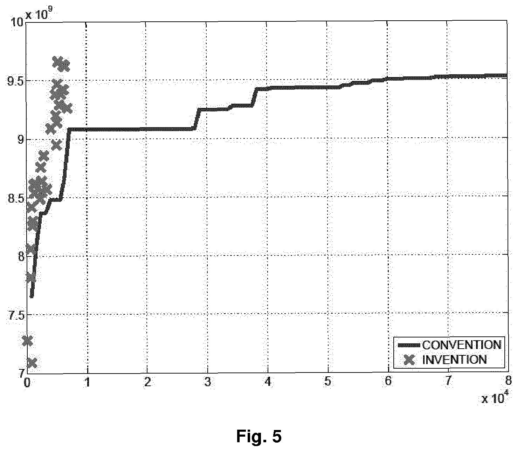

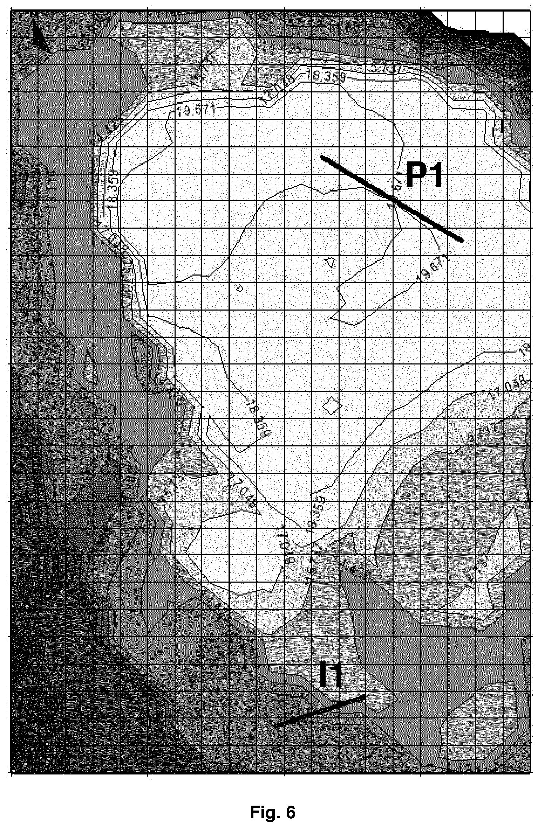

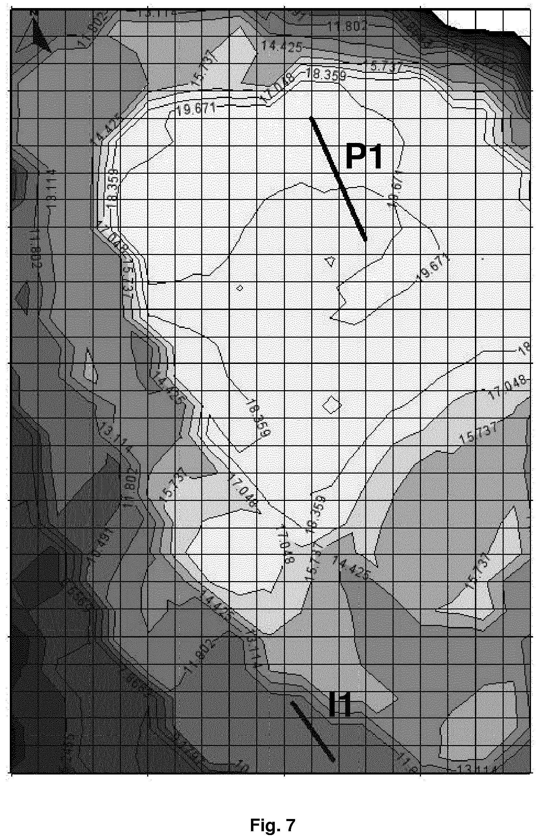

On montre aussi que la méthode selon l'invention est presque 16 fois plus rapide (16 fois de moins en nombre de simulation) que la méthode conventionnelle. La figure 5 montre l'évolution de la meilleure valeur de NPV trouvé en utilisant la méthode selon l'invention et la compare avec celle trouvée en utilisant l'approche conventionnelle. L'axe des abscisses présente le nombre de simulations de réservoir utilisées. L'axe des ordonnées présente la valeur du NPV. Dans cet exemple d'application, la méthode conventionnelle est basée sur une optimisation basée sur la méthode CMA-ES du vrai critère de qualité. La figure 6 montre les positions des configurations de zones de drainage obtenues en utilisant la méthode selon la méthode conventionnelle. La figure 7 montre les positions des configurations de zones de drainage obtenues en utilisant la méthode selon l'invention. Les positions de zones de drainage sont proches et les valeurs de critères de qualités sont équivalentes, mais nous avons besoin de beaucoup moins de temps pour déterminer la zone de drainage selon l'invention.

## Revendications

**1.** Procédé d'exploitation d'un réservoir souterrain, à partir d'un ensemble de modèles de réservoir construits à partir de mesures collectées du réservoir et à l'aide d'une méthode géostatistique, au moyen d'un simulateur d'écoulement, ledit simulateur étant un logiciel exécuté sur ordinateur, ledit simulateur permettant d'estimer des quantités produites d'eau, d'huile et de gaz pour une configuration de puits et pour un intervalle de temps, dans lequel on définit un nombre de puits à forer au sein du réservoir, **caractérisé en ce que** l'on détermine des emplacements desdits puits en réalisant les étapes suivantes :

i) on génère aléatoirement des configurations de puits, chaque configuration correspondant à des emplacements possibles des puits ;

ii) on optimise, au moyen d'un algorithme d'optimisation stochastique, lesdites configurations en calculant un premier critère de qualité Q de l'exploitation du réservoir au moyen dudit simulateur d'écoulement appliqué à un nombre restreint desdits modèles de réservoir et au moyen de résultats de simulations de configuration obtenus préalablement pour des configurations proches, par rapport à une distance, de la configuration à évaluer, ladite distance étant fonction des coordonnées des puits, des paramètres dudit algorithme d'optimisation étant initialisés à partir desdites configurations de puits issues de l'étape i) et lesdits paramètres étant modifiés au moyen dudit algorithme d'optimisation de façon à maximiser ledit premier critère de qualité, ladite optimisation se poursuivant jusqu'à atteindre un critère d'arrêt fixé, ledit premier critère Q associé à une desdites configurations à optimiser étant défini selon la formule suivante :

$$Q = \sum_{j=1}^{N_M} p_j C_j + \sum_{i=1}^{N_S} \widetilde{p}_i \widetilde{C}_i$$

où :

- $N_S$ est nombre desdites configurations préalablement simulées ;
- $N_m$ est ledit nombre restreint de modèles de réservoir ;
- $\widetilde{C}_i$ est ledit résultat de simulation préalablement obtenu pour une desdites $N_S$ configurations préalablement simulées ;
- $C_j$ est un résultat de simulation obtenu pour ladite configuration à évaluer et pour un desdits $N_M$ modèles de réservoir ;
- $p_j$ est un poids affecté audit résultat de simulation $C_j$ obtenu pour ladite configuration à évaluer et pour un desdits $N_M$ modèles de réservoir ;
- $\widetilde{p}_i$ est un poids affecté audit résultat de simulation préalablement obtenu $\widetilde{C}_i$ pour une desdites $N_S$ configurations préalablement simulées ;

iii) on calcule pour lesdites configurations optimisées, un second critère de qualité de l'exploitation du réservoir au moyen dudit simulateur d'écoulement appliqué à chacun desdits modèles de réservoir, et l'on choisit l'emplacement des puits correspondant à la configuration optimisée ayant le meilleur second critère de qualité, ledit second critère de qualité C étant défini selon la formule suivante :

$$C = \frac{1}{N_M} \sum_{j}^{N_M} C_j$$

où $C_j$ est un résultat de simulation obtenu pour ladite configuration optimisée et pour un desdits $N_M$ modèles de réservoir;

iv) on fore lesdits puits aux emplacements choisis.

2. Procédé selon la revendication 1, dans lequel lesdits résultats de simulations de configuration obtenus préalablement sont obtenus au cours de l'optimisation.

3. Procédé selon la revendication 1, dans lequel lesdits résultats de simulations de configuration obtenus préalablement sont obtenus en calculant ledit second critère de qualité.

4. Procédé selon l'une des revendications précédentes, dans lequel les premier et second critères de qualité correspondent à une valeur présente nette NPV caractéristique de tous lesdits modèles de réservoir.

5. Procédé selon l'une des revendications précédentes, dans laquelle on réitère le procédé en faisant varier le nombre de puits.

6. Procédé selon l'une des revendications précédentes, dans lequel on optimise lesdites configurations au moyen d'un algorithme de type CMA-ES.

7. Procédé selon l'une des revendications précédentes, dans lequel lesdits puits à forer comportent des drains multi-branches.

**Patentansprüche**

1. Verfahren zur Ausbeutung einer unterirdischen Lagerstätte anhand einer Gesamtheit von Lagerstättenmodellen, die anhand von gesammelten Messwerten der Lagerstätte und mithilfe eines geostatistischen Verfahrens erstellt werden, mittels eines Fließsimulators, wobei der Simulator eine auf einem Computer ausgeführte Software ist, wobei der Simulator ermöglicht, geförderte Mengen an Wasser, an Öl und an Gas für eine Konfiguration von Bohrlöchern und für ein Zeitintervall, in welchem ein Anzahl von innerhalb der Lagerstätte zu bohrenden Bohrlöchern definiert wird, zu schätzen, **dadurch gekennzeichnet, dass** Standorte der Bohrlöcher bestimmt werden, indem die folgenden Schritte ausgeführt werden:

i) Es werden zufällig Konfigurationen von Bohrlöchern erzeugt, wobei jede Konfiguration möglichen Standorten der Bohrlöcher entspricht;
ii) die Konfigurationen werden mittels eines stochastischen Optimierungsalgorithmus optimiert, indem ein erstes Qualitätskriterium Q der Ausbeutung der Lagerstätte mittels des auf eine begrenzte Anzahl der Lagerstättenmodelle angewendeten Fließsimulators und mittels der Ergebnisse von Konfigurationssimulationen, die zuvor für Konfigurationen erhalten wurden, die der zu bewertenden Konfiguration bezüglich eines Abstands nahe sind, berechnet wird, wobei dieser Abstand von den Koordinaten der Bohrlöcher abhängig ist, wobei Parameter des Optimierungsalgorithmus anhand der Konfigurationen von Bohrlöchern aus Schritt i) initialisiert werden und diese Parameter mittels des Optimierungsalgorithmus so modifiziert werden, dass das erste Qualitätskriterium maximiert wird, wobei die Optimierung fortgesetzt wird, bis ein festgelegtes Abbruchkriterium erfüllt ist, wobei das erste Kriterium Q, das einer der zu optimierenden Konfigurationen zugeordnet ist, gemäß der folgenden Formel definiert ist:

$$Q = \sum_{j=1}^{N_M} p_j C_j + \sum_{i=1}^{N_S} \tilde{p}_i \tilde{C}_i \, ,$$

wobei:

- $N_S$ die Anzahl der zuvor simulierten Konfiguration ist;
- $N_M$ die begrenzte Anzahl von Lagerstättenmodellen ist;
- $\tilde{C}_i$ das Simulationsergebnis ist, das zuvor für eine der zuvor simulierten $N_S$ Konfigurationen erhalten wurde;
- $C_j$ ein Simulationsergebnis ist, das für die zu bewertende Konfiguration und für eines der $N_M$ Lagerstät-tenmodelle erhalten wurde;
- $p_j$ ein Gewicht ist, das dem Simulationsergebnis $C_j$ zugewiesen ist, das für die zu bewertende Konfiguration und für eines der $N_M$ Lagerstättenmodelle erhalten wurde;
- $\tilde{p}_i$ ein Gewicht ist, das dem Simulationsergebnis $\tilde{C}_i$ zugewiesen ist, das zuvor für eine der $N_S$ zuvor simulierten Konfigurationen erhalten wurde;

iii) für die optimierten Konfigurationen wird ein zweites Qualitätskriterium der Ausbeutung der Lagerstätte mittels des auf jedes der Lagerstättenmodelle angewendeten Fließsimulators berechnet, und es wird der Standort der Bohrlöcher gewählt, welcher der optimierten Konfiguration entspricht, die das beste zweite Qualitätskriterium aufweist, wobei das zweite Qualitätskriterium C gemäß der folgenden Formel definiert ist:

$$C = \frac{1}{N_M} \sum_{j}^{N_M} C_j \, ,$$

wobei $C_j$ ein Simulationsergebnis ist, das für die optimierte Konfiguration und für eines der $N_M$ Lagerstättenmodelle erhalten wurde;
iv) die Bohrlöcher werden an den gewählten Standorten gebohrt.

2. Verfahren nach Anspruch 1, wobei die zuvor erhaltenen Ergebnisse von Konfigurationssimulationen im Verlaufe der Optimierung erhalten werden.

3. Verfahren nach Anspruch 1, wobei die zuvor erhaltenen Ergebnisse von Konfigurationssimulationen erhalten werden, indem das zweite Qualitätskriterium berechnet wird.

4. Verfahren nach einem der vorhergehenden Ansprüche, wobei das erste und das zweite Qualitätskriterium einem Nettokapitalwert NPV entsprechen, der für alle diese Lagerstättenmodelle charakteristisch ist.

5. Verfahren nach einem der vorhergehenden Ansprüche, wobei das Verfahren wiederholt wird, wobei man die Anzahl der Bohrlöcher variieren lässt.

6. Verfahren nach einem der vorhergehenden Ansprüche, wobei die Konfigurationen mittels eines Algorithmus vom Typ CMA-ES optimiert werden.

7. Verfahren nach einem der vorhergehenden Ansprüche, wobei die zu bohrenden Bohrlöcher Dräne mit mehreren Zweigen aufweisen.

**Claims**

1. Method for exploiting an underground reservoir, based on a set of reservoir models constructed, from measurements collected from the reservoir and using a geo-static method, by means of a flow simulator, said simulator being a software package executed on computer, said simulator allowing amounts of water, of oil and of gas produced for a well configuration and for a time interval to be estimated, wherein a number of wells to be drilled within the reservoir is defined, **characterized in that** locations of said wells are determined by carrying out the following steps:

i) well configurations are randomly generated, each configuration corresponding to possible locations of the well;
ii) said configurations are optimized, by means of a stochastic optimization algorithm, by computing a first quality criterion Q of the exploitation of the reservoir by means of said flow simulator applied to a restricted number of said reservoir models and by means of configuration-simulation results obtained beforehand for configurations that are similar, with respect to a distance, to the configuration to be evaluated, said distance depending on the coordinates of the wells, parameters of said optimization algorithm being initialized based on said well configurations generated in step i) and said parameters being modified by means of said optimization algorithm so as to maximize said first quality criterion, said optimization continuing until a set termination criterion is reached, said first criterion Q associated with one of said configurations to be optimized being defined by the following formula:

$$Q = \sum_{j=1}^{N_M} p_j C_j + \sum_{i=1}^{N_S} \tilde{p}_i \tilde{C}_i$$

where:

- $N_S$ is the number of said configurations simulated beforehand;
- $N_M$ is said restricted number of reservoir models;
- $\tilde{C}_i$ is said simulation result obtained beforehand for one of said $N_S$ configurations simulated beforehand;
- $C_j$ is a simulation result obtained for said configuration to be evaluated and for one of said $N_M$ reservoir models;
- $p_j$ is a weight assigned to said simulation result $C_j$ obtained for said configuration to be evaluated and for one of said $N_M$ reservoir models;
- $\tilde{p}_i$ is a weight assigned to the said simulation result $\tilde{C}_i$ obtained beforehand for one of said $N_S$ configurations simulated beforehand;

iii) for said optimized configurations, a second quality criterion of the exploitation of the reservoir is computed by means of said flow simulator applied to each of said reservoir models, and the location of the wells corresponding to the optimized configuration having the best second quality criterion is chosen, said second quality criterion C being defined by the following formula:

$$C = \frac{1}{N_M} \sum_{j}^{N_M} C_j$$

where $C_j$ is a simulation result obtained for said optimized configuration and for one of said $N_M$ reservoir models;
iv) said wells are drilled in the chosen locations.

2. Method according to Claim 1, wherein said configuration-simulation results obtained beforehand are obtained during the optimization.

3. Method according to Claim 1, wherein said configuration-simulation results obtained beforehand are obtained by computing said second quality criterion.

4. Method according to one of the preceding claims, wherein the first and second quality criteria correspond to a net present value NPV characteristic of all said reservoir models.

5. Method according to one of the preceding claims, wherein the method is reiterated while varying the number of wells.

6. Method according to one of the preceding claims, wherein said configurations are optimized by means of a CMA-ES algorithm.

7. Method according to one of the preceding claims, wherein said wells to be drilled comprise multi-branch drains.

**Fig. 1**

**Fig. 2**

**Fig. 3**

**Fig. 4**

**Fig. 5**

Fig. 6

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **GUYAGULER, B. ; HORNE, R.N.** *Uncertainty assessment of well placement optimization. In: SPE annual technical conférence and exhibition,* 2001
- **OZDOGAN, U. ; HORNE, R.N.** Optimization of Well Placement Under Time-Dependent Uncertainty. *SPE Res Eval & Eng,* 2006, vol. 9 (2), 135-145
- **ALHUTHALI, A.H. ; DATTA-GUPTA, A. ; YUEN, B. ; FONTANILLA, J.P.** Optimizing smart well controls under geologic uncertainty. *Journal of Petroleum Science and Engineering,* 2010, vol. 73 (1-2), 107-121
- **SCHULZE-RIEGERT, R. ; BAGHERI, M. ; KROSCHE, M. ; KUCK, N. ; MA, D.** Multiple-objective optimization applied to well path design under geological uncertainty. *In SPE reservoir simulation symposium,* 2011
- **WANG, H. ; ECHEVERRIA CIAURRI, D. ; DURLOFSKY, L.J. ; COMINELLI, A.** Optimal well placement under uncertainty using a Retrospective Optimization framework. *SPE Reservoir Simulation Symposium,* 2011
- **N. HANSEN ; A. OSTERMEIER.** Completely derandomized self-adaptation in évolution strategies. *Evolutionary Computation,* 2001, vol. 9 (2), 159-195